(19) Europäisches Patentamt
European Patent Office
Office européen des brevets

(11) **EP 2 249 372 B1**

(12) **EUROPEAN PATENT SPECIFICATION**

(45) Date of publication and mention
of the grant of the patent:
**02.01.2013 Bulletin 2013/01**

(51) Int Cl.:
***H01J 37/32*** *(2006.01)*

(21) Application number: **10170734.7**

(22) Date of filing: **11.07.2008**

(54) **Method for controlling ion energy in radio frequency plasmas**

Verfahren zur Steuerung der Ionenenergie in Radiofrequenz-Plasmen

Procédé de réglage de l'énergie des ions dans des plasmas radiofréquences

(84) Designated Contracting States:
**AT BE BG CH CY CZ DE DK EE ES FI FR GB GR HR HU IE IS IT LI LT LU LV MC MT NL NO PL PT RO SE SI SK TR**

(43) Date of publication of application:
**10.11.2010 Bulletin 2010/45**

(62) Document number(s) of the earlier application(s) in accordance with Art. 76 EPC:
**08786101.9 / 2 122 657**

(73) Proprietor: **Ruhr-Universität Bochum
44801 Bochum (DE)**

(72) Inventors:
• **Heil, Brian George
65199, Wiesbaden (DE)**
• **Czarnetzki, Uwe
44879, Bochum (DE)**
• **Brinkmann, Ralf-Peter
40699, Erkrath (DE)**
• **Mussenbrock, Thomas
42283, Wuppertal (DE)**

(74) Representative: **Richardt Patentanwälte GbR
Wilhelmstraße 7
65185 Wiesbaden (DE)**

(56) References cited:
WO-A1-99/14699          US-A1- 2003 164 142
US-A1- 2004 000 875    US-A1- 2006 113 037
US-A1- 2007 023 398

• SCHULZE J ET AL: "Space and phase resolved plasma parameters in an industrial dual-frequency capacitively coupled radio-frequency discharge; Space and phase resolved plasma parameters in dual-frequency CCRF discharge" JOURNAL OF PHYSICS D. APPLIED PHYSICS, IOP PUBLISHING, BRISTOL, GB, vol. 40, no. 22, 21 November 2007 (2007-11-21), pages 7008-7018, XP020126757 ISSN: 0022-3727

**Description**

Technical field

The present invention relates to the field of modification of surfaces and materials by exposure to low pressure plasmas and gases.

Background and related art

It is well known in the art that the flux and energy of ions is important in determining how a plasma treatment will affect a workpiece. There exist several different methods of adjusting the ion energy during plasma treatment, none of which are generally applicable.

Coburn and Kay, J. Appl. Phys. 43(12):4965-4971 (1972) (cited as Coburn) describes a geometrically based Direct Current (DC) offset effect that depends upon a Radio Frequency (RF) voltage being applied across electrodes immersed in a plasma which have different surface areas. The method of Coburn is commonly used in the semiconductor industry for the manufacture of integrated circuits, and is implemented by placing a silicon wafer upon an electrode immersed in a plasma. Typically, the wall of the vacuum chamber functions as a second electrode and has a significantly larger surface area than the electrode with the wafer. This causes an increase in the average energy of ions striking the silicon wafer. This technique is not applicable when the workpiece has a very large surface area, because the vacuum chamber would be prohibitively large. An example would be a photovoltaic module manufactured using thin films. These modules typically have a surface area greater than a square meter.

There have also been methods developed where multiple RF voltages are applied to one or more electrodes. Boyle, Ellingboe, and Turner, J. Phy. D: Appl. Phys 37:697-701 (2004) (cited as Boyle) describes how a low frequency is used to modulate the ion energy, and a large frequency is used to control plasma production. The abstract of Boyle states that: "In such discharges, a low frequency component couples predominantly to the ions, while a high frequency component couples predominantly to electrons. Thus, the low frequency component controls the ion energy, while the high frequency component controls the plasma density. Clearly this desired behavior is not achieved for arbitrary configurations of the discharge, and in general one expects some unwanted coupling of ion flux and energy."

The method described in Boyle is commonly used in the semiconductor industry, and has been only partially successful in allowing the independent control of ion flux and energy. The method described in Boyle is also difficult to apply to large workpieces due to standing wave effects caused by the high frequency RF voltage.

XP 20126757 (Schulze et al) discloses a plasma treatment method where the ability to separately control electron density and ion energy is limited due to the fact that the temporal variation of the high energy states is complex and depends on the high and low frequency component.

Summary of the invention

The embodiment of the invention provides a method of electrically inducing an asymmetry in the electric fields of sheaths of electrodes exposed to a plasma. This induced asymmetry allows the energy and flux of ions striking a surface to be independently controlled. Embodiments of the present invention solve the technical shortcomings of the prior art. Embodiments of the present invention can be used for plasma treating substrates with arbitrarily large surface areas and there is a clear methodology for adjusting the ion energy.

The ion energy and flux can be independently controlled by applying one or more RF voltages across the discharge. The difference between embodiments of the present invention and the prior art is that two or more harmonic components of the applied RF voltage are even harmonics of each other, and that they have a controlled relative phase. The Appendix provides more background information and a description of additional benefits of the invention. The Appendix provides examples of how the DC bias, and hence the ion energy, is adjusted by controlling the relative phase of the harmonic components of the applied RF voltage.

Embodiments of the invention relate to a method for causing an asymmetry in the electric fields of the plasma sheath region. The average electric field in the sheath region affects the energy that ions have when they strike a workpiece. As a result, this asymmetry in the sheath allows the independnet control of the ion flux and the ion energy received by a workpiece during plasma treatment. Embodiments of the invention work by placing a RF voltage across the discharge. The RF voltage is comprised of at least two harmonic componets that are even harmoics of each other and that have a controlled relative phase.

The present invention provides a method of adjusting a DC self-bias in front of at least one electrode in a plasma operating apparatus by applying a RF voltage as is described in independent claim 1. Embodiments are described in dependent claims 2 through 12. As a note, to conduct a RF current through the plasma, it is obvious that two or more electrodes are needed for the conduction path. However, in the art it is typical to speak of adding a single electrode to the discharge. In this case, it is understood that the second electrode is a part of the vacuum chamber wall or another surface such as part of the vacuum pump that functions as an electrode. This method of adjusting a DC self-bias has the advantage that, the flux of ions and the energy of these ions to a workpiece or substrate exposed to the plasma can be controlled independently. Current methods do not allow for such independent control of these two plasma treatment parameters, and this method works in situations where current methods do not. In particular it allows the control of the ion flux and ion energy for workpieces with a large surface area.

In another respect, the DC self-bias in front of an electrode with a workpiece can be dynamically controlled. This would be accomplished by varying the amplitudes of the harmonic components that make up the applied RF voltage as a function of time and by varying the relative phase between these components as a function of time. This has the advantage that plasma processes could be adjusted during the process. If a material is being deposited on the workpiece, its properties such as the tension in a thin film, its composition, or internal structure could be varied during the plasma process. During an etching process, the properties of the ions could be tailored to optimize the etching process as the surface being etched changes. This has implications in the semiconductor industry where very deep and narrow trenches are cut using plasma processes. The uniformity and straightness of these trenches depends greatly upon the number and the properties of ions entering the trenches.

In another respect, if the at least two harmonics of the applied RF voltage that are even harmonics of each other are applied to the same electrode it is particularly advantageous. This has the advantage that an embodiment of the invention can be constructed by adding only a single electrode to the system. There exist many different embodiments of the invention for different types of plasma sources. Several of these will be detailed below in the Detailed Description.

In another respect, and embodiment of the invention will work if the applied RF voltage is applied to more than one electrode. It is important that the relative phases of voltage components that are an even multiple of each other are controlled. Splitting the applied RF voltage across several electrodes has the advantage that the method can be applied to more complex types of plasma operating apparatuses. The technique can also be applied when the relative phase of the harmonic components that are an even multiple of each other are fixed during a plasma treatment.

In another respect, constructing the applied RF voltage from the fundamental frequency of the applied RF voltage and its second harmonic has the advantage that, the ion energy varies as a linear function of the phase angle between the two. This clear and straight forward relationship between the ion energy and the phase angle allows the ion energy to be easily controlled and adjusted to a desired value during a manufacturing process. This relationship between the phase angle and the ion energy is demonstrated analytically and with a simulation in the Appendix. For the case shown in the Appendix, the amplitudes of the harmonic components were the same.

In another respect, aspects of the invention can be geometrically symmetric, capacitively coupled radio-frequency plasmas. Capacitively coupled plasmas (CCP) typically have two or more electrodes exposed to a plasma. A geometrically symmetric CCP is when the CCP has two electrodes, and the surface area of the two electrodes are effectively the same. This is an extremely significant application of the method. In the semiconductor industry, the geometry based asymmetry effect is used to modify the ion energy of ions striking a substrate. If a large substrate is used, such as for a photovoltaic panel or a flat television screen, it is not possible to use the geometry based effect. The vacuum chamber would need to be prohibitively large. The method can be applied to manufacturing processes to which it is not possible using current methods. This is also an extremely novel application. It is not known in the art that a symmetric CCP can be made electrically asymmetric.

In another respect, the asymmetry of the sheaths between the plasma and the electrodes can be controlled by adjusting the relative phase of the harmonic components of the applied RF voltage. The total power absorbed into the plasma will affect the production of plasma, and hence the plasma density. The Root Mean Square (RMS) value of the applied RF voltage does not change as relative phases between its harmonic components change. This has the advantage that the power absorbed by the plasma remains nearly constant as the phase is adjusted. This allows the ion energy to be adjusted without large changes in the ion flux.

In another respect, embodiments of the invention can have an additional electrode added to a plasma operating apparatus that is independent of the excitation method of the plasma. When a plasma is generated using a particular type of plasma source, the plasma will have a particular density and there will be a particular ion flux with a particular ion energy received by a substrate exposed to the plasma for a given set of plasma operating conditions. Applying the method to different types of plasma sources has the advantage, that different combinations of ion flux and energy will be available for plasma processing. A variety of embodiments with different plasma sources are described below in the Detailed Description.

In another respect, aspects of the invention can be constructed with an inductively coupled or microwave plasma source through an additional electrode. The addition of an additional electrode in these sources is very common, and is called an "RF Wafer Chuck." A DC bias is generated in front of the electrode using the geometrically based self bias effect and used to adjust the ion energy. Embodiments of the invention are also applicable to this case. The invention has the advantage that, the ion energy would be more adjustable. The electrical asymmetry would augment the geometrically based DC self bias effect.

In another aspect, aspects of the invention relate to CCP. These discharges are generated and sustained by the RF voltage applied to the electrodes. Applying the method to plasmas generated by the same RF voltage that establishes the DC bias has the advantage that, the overall design of the plasma operating apparatus is simpler. It is also advantageous, because the invention can be applied to plasma operating apparatuses that are commonly used in industry.

In another aspect, the invention relates to the modification of surfaces exposed to plasmas. This is an advantage because, the flux and energy of ions striking a workpiece exposed to a plasma has a large effect on the structure and composition of the material. When an ion strikes the surface of a workpiece it imparts energy to the surface. For instance, this energy can cause chemical bonds to break or impart energy to atoms or molecules and allow a change in the physical structure of the surface. Controlling the ion energy and flux allows better control of surface modification during a plasma treatment.

In another aspect the invention relates to the etching of surfaces during plasma treatment. This is an advantage, because the ion flux and energy affects the uniformity and control of etching processes. Of particular interest is the etching of dielectric substrates or workpieces during the manufacture of semiconductor devices. These processes require uniformity over large areas, and precise control over the plasma to ensure that trenches cut during the etching process are uniform.

In another aspect the invention relates to the manufacture of semiconductor devices, Micro Electro Mechanical Systems (MEMS) devices, solar cell (photovoltaic) panels, and flat television screens. Embodiments of the invention have the advantage that the precise control of the DC offset and hence the control of the ion energy allows precise control of the manufacturing process for these products. Embodiments of the invention are particularly advantageous for the manufacture of photovoltaic panels and flat television screens. The large surface area of these products prevents the use of the methods currently known in the art. The large surface area of the substrate prevents the use of the geometrically based DC offset effect, because the vacuum chamber would need to be too large to be of practical use in manufacturing. Dual-frequency or Multi-frequency techniques would not be useable because the dimensions of the substrate are so large that the high frequency component of the applied voltage will have standing wave problems and the plasma will not be uniform.

In another aspect the invention relates to plasmas used for the sputtering of surfaces, gas phase surface modification, surface cleaning, the controlling of surface energies, improving biocompatibility, the promotion of adhesion, the manufacture of nanoparticles, the assembly of nanoparticles into structures, and/or the surface cross linking of structures. This has the advantage that new manufacturing processes can be developed. Combinations of ion energies and fluxes that were not previously possible can now be achieved. As was mentioned previously, the flux of ions and the energy of ions striking a surface exposed to a plasma affects the structure between atoms and molecules on the surface. If new combinations of ion energy and fluxes are available, new processes can be developed where the materials and surfaces have improved or new properties.

A plasma operating system comprising a discharge of a capacitively coupled radio-frequency plasma can be constructed wherein the ion flux and ion energy can be separately controlled.

This plasma operating system has the advantage that, it allows a greater control of the plasma processes performed in it in comparison with the current art. Again, it is understood that at least two electrodes are necessary to conduct electrical current through the plasma and that one electrode is the vacuum chamber wall and/or another surface such as part of a vacuum pump exposed to the plasma.

An aspect further provides for a method of independently controlling ion flux and ion energy in a plasma. The method modifies the ion energy by causing an asymmetry in the electric fields in the sheath of the electrodes as is described in the Appendix. To achieve this particular ion energy and ion flux, the power absorbed by the plasma is chosen. The power can be deposited into the plasma using a variety of different methods. A few examples would be a capacitive source, a microwave source, an inductive source, Neutral Loop Discharge (NLD), or a helicon discharge. The RF voltage that is applied to the plasma for adjusting the ion flux and/or ion energy also contributes to the total power absorbed by the plasma and needs to be considered also. The ion energy is then adjusted by adjusting the harmonic components of the applied RF voltage.

In another aspect, embodiments of the invention can be constructed by applying the RF voltage across two or more electrodes. This has the advantage that well defined electrodes define where the modification of the plasma sheath will occur, and also clearly define the path of the RF current induced by the application of the RF voltage. When the path of the RF current is not clearly defined the RF current can take different paths through plasma and through different parts of the apparatus. This can cause changes in the impedance of the plasma and instabilities during the plasma treatment.

In another respect, aspects of the invention can use the workpiece as an electrode or can place the workpiece on a surface or directly adjacent to an electrode. This has the advantage that the workpiece receives the maximum benefit of adjusting the ion energy and/or ion flux. This is because the change in the ion flux and energy are adjusted the most in the sheath adjacent to an electrode or surface that functions as an electrode. When a workpiece is conductive and is in contact with an electrode then the workpiece functions as an electrode also. When a workpiece is made from a dielectric material, the workpiece should be placed in the sheath region of the electrode to receive the maximum benefit. Dielectric workpieces within the sheath region function as part of a capacitor. Flat substrates such as silicon wafers used for the manufacture of semiconductors are particularly easy to place within the sheath region of an electrode.

In another respect, embodiments of the invention can adjust the ion energy by adjusting the relative phase between the harmonic components of the applied RF voltage which are even harmonics of each other. The RMS value of the applied RF voltage is independent of the relative phase of its harmonic components. As a result, adjusting the relative phase will change the ion energy while the ion flux will see negligible changes.

In another aspect, the method of independently controlling the ion flux and ion energy can be modified by limiting the applied RF voltage to the case where the harmonic components are comprised of only the fundamental and its second harmonic. This has the advantage that the control of the ion energy is maximized and that the ion energy varies linearly as the phase between the fundamental and the second harmonic changes. The control of the ion energy depends upon the temporal asymmetry of the voltage applied to the electrodes. This effect is maximized by making the harmonics which have frequencies that are even multiples of each other as close in frequency as possible. This is of course optimized by choosing the fundamental and the second harmonic. Using just two harmonic components has the advantage that the RF circuitry would be less complicated. Including additional harmonics would add complexity and cost to the RF generating system. The Appendix contains details of the linear relationship between the ion energy and the phase angle for this case.

In another aspect, the method of independently controlling the ion flux and ion energy can be modified by using a lookup table to determine the phases and amplitudes of the harmonic components of the RF voltage necessary for a particular ion flux and ion energy. It can be expected the operator would use a combination of experiments and/or calculations to determine the optimum voltages. Examples of instruments or sensors that one could perform such experiments are discussed below. Examples of calculations are shown in the Appendix. This has the advantage, that the proper amplitudes, voltages, and phases of the RF voltage could be determined quickly.

In another aspect, the method of independently controlling the ion flux and ion energy can be modified by adjusting the ion flux and or ion energy based on measurements from sensors and/or instruments as described in dependent claim 37. An instrument is a measurement device which returns a calibrated measurement of some physical property. A sensor is the same as an instrument, except that the result is not calibrated. Examples of sensors or instruments that would provide useful measurements include: Langmuir probe, ion flux probe, Faraday cup, retarding field analyzer (for ion energies and fluxes), quadrupole mass spectrometer, and sensors that measure the harmonic components and/or phase of the RF voltage. This has the advantage that, changes in the plasma or the workpiece could be adjusted during a plasma treatment. For example, in the semiconductor industry it is very common to deposit thin films with a plasma. During the deposition process or over the course of many deposition processes materials can be deposited on the walls of the vacuum chamber. This can affect electrical properties in the vacuum chamber in which the plasma is generated. Adjusting the plasma process using sensor measurements would allow the chamber to be used for a longer time without having to clean the vacuum chamber and would prevent the change of the plasma treatment over time. This would reduce manufacturing cost.

In another respect, aspects of the invention could allow for dynamic changes in the ion flux and the ion energy as described in dependent claim 38. A dynamic change is defined to mean a change which occurs in time. For example, if the ion energy changes dynamically, then the ion energy changes as a function of time during the plasma treatment. This is an advantage, because the ion flux and the ion energy can be used to deposit more complex materials on a substrate or optimize the etching of a substrate. When thin films are deposited by a plasma on a substrate, the layer is built up over time. If the ion flux and ion energy change during the deposition then the structure of the film can be adjusted. During the manufacture of semiconductor devices it is common to etch trenches with high aspect ratios. The profile of these trenches depends greatly upon the number of ions penetrating into the trench. Adjusting the ion energy and flux could be used to optimize the process during the different stages of when the trench is cut.

In another respect, aspects of the invention could include a computer program product for performing the method. This has the advantage that complex models and lookup tables could be used for choosing and optimizing the ion flux and ion energy during a plasma treatment. It may require too much time for a human operator to properly calculate the values to use to control the plasma apparatus.

There is further provided a controller for controlling a plasma apparatus. This has the advantage that the ion flux and the ion energy can be controlled as independent parameters. In the current art, an operator sets the power to be deposited into a plasma. Embodiments of the controller could allow an operator to choose the ion flux and energy directly.

There is further provided a method of causing an asymmetry in the sheath adjacent to two or more electrodes exposed to a plasma. This has the advantage that the properties of the sheaths in front of the different electrodes have different physical properties and this allows for the modification and adjustment of plasma treatments. This asymmetry is described in the Appendix. The control of the ion energy and the control of the DC bias in front of an electrode are manifestations of this asymmetry. The method not only causes an electric asymmetry in the sheaths, but also a physical asymmetry. The plasma sheath region in front of an electrode depends upon the strength of the electric field across the sheath. As a DC bias increases, the sheath region will grow larger.

Brief description of the drawings

In the following preferred embodiments of the invention are described in greater detail by way of example only making reference to the drawings in which:

Fig. 1 is a schematic of a plasma operating apparatus.
Fig. 2 is a schematic of an RF voltage system that is part of an embodiment of the invention,
Fig. 3 is a flow diagram of an embodiment of a method of performing the invention.
Fig. 4 is a schematic of an embodiment of a controller for automating an embodiment of the method of the invention,
Figs. 5-9 are schematics of plasma operating apparatuses that incorporate embodiments of the invention.

Detailed Description

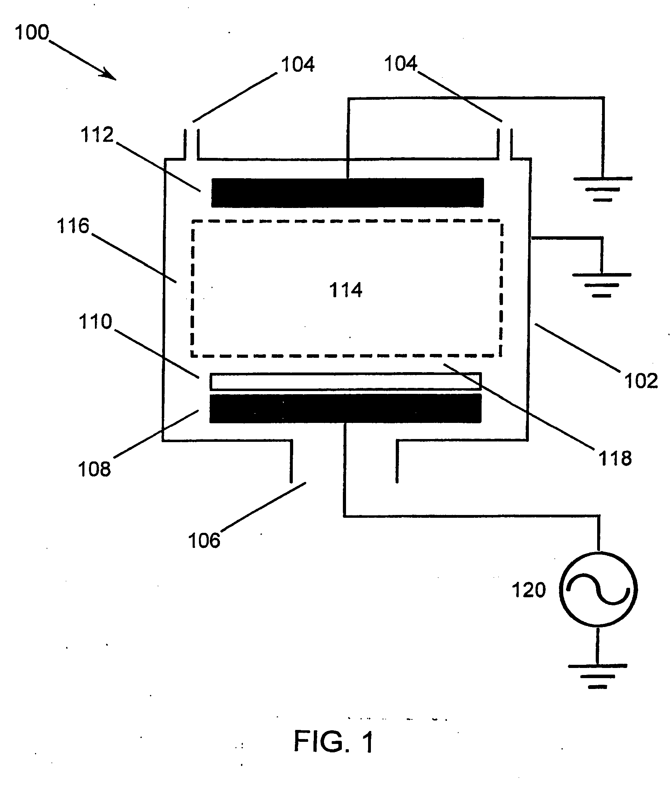

Fig. 1 shows a cross-sectional view of an idealized plasma operating apparatus with a capacity coupled plasma source. Other figures that show aspects of plasma operating apparatuses are displayed in the same way. Aspects of the invention using a variety of plasma sources will be detailed below to demonstrate the wide applicability of the invention. Components in these figures are denoted with a three digit number. Components which are identical use the same number throughout all of the figures. If components are similar or have the same function, then the last two digits are identical.

The plasma operating apparatus shown in Fig. 1 comprises a vacuum chamber wall 102, a gas inlet 104, a vacuum outlet 106, a powered electrode 108, a grounded electrode 112, and an RF voltage system 120. A plasma 114 is generated in the volume of the chamber in between the powered electrode 108 and the grounded electrode 112. The invention works by applying an RF voltage using RF voltage system 120 to the powered electrode 108, where the voltage applied to the powered electrode 108 consists of two RF voltages which are even harmonics of each other and the phase relationship between the two is controlled. In this example the substrate 110 is shown as being placed directly in front of the powered electrode 108, however the substrate could also be placed in front of the grounded electrode 112. The specific embodiment of the invention is also not dependent upon the RF voltage system 120, it is only necessary that the RF voltage applied to the powered electrode 108 has at least two harmonic components which have a controlled relative phase.

In between the plasma 114 and any surface exposed to the plasma a boundary layer or a plasma sheath develops between the two. The plasma 114 is very conductive and the voltage drop across the plasma 114 is very small. The majority of the voltage drop is across the sheath regions 116. In order to expose a substrate to plasma processing a substrate 110 is inserted into the plasma in front of the powered electrode 108 between the powered electrode 108 and the plasma 114. The electric field in front of the powered electrode in the sheath region 118 accelerates ions towards the substrate 110. The effect of the electric field in the sheath region on ions is discussed in the Appendix. The invention modifies the electric field in front of both the powered electrode 108 and the grounded electrode 112.

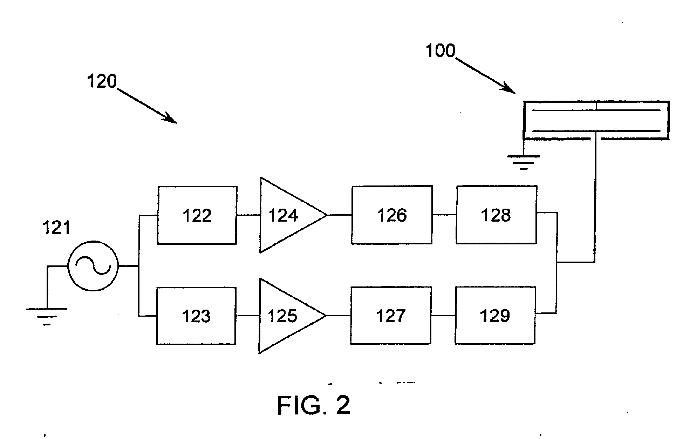

Fig. 2 shows an RF voltage system used for the invention and its relationship to a capacity coupled plasma operating apparatus 100. The RF voltage system is comprised of an RF voltage generator 121, a phase shifter 122, a frequency doubler 123, an RF amplifier 124, an RF amplifier 125, a low pass filter 128, and a high pass filter 129. This RF voltage system produces an RF voltage which is comprised of a fundamental and its second harmonic. The RF voltage generator is connected to the input of both the phase shifter 122 and the frequency doubler 123. The purpose of a phase shifter is to control the relative phase of the two harmonic components. The purpose of the frequency doubler is to produce the second harmonic. The output of the phase shifter is connected to the input of RF amplifier 124 and the output of frequency doubler 123 is connected to the input of RF amplifier 125. The output of RF amplifier 124 is connected to the input of impedance matching network 126 and the output of impedance matching network 126 is into the input of the low pass filter 128. The purpose of the low pass filter is to prevent RF power from the second harmonic from entering the matching network of the fundamental. The output of RF amplifier 125 is connected to the input of impedance matching network 127. The output of the impedance matching network 127 is into the input of the high pass filter 129. The purpose of the high pass filter is to prevent RF energy from the fundamental from entering the matching network of the second harmonic. The output of the low pass filter 128 and the output of the high pass filter 129 are connected to the powered electrode 108 of the capacitively coupled plasma operating apparatus 100.

This system could be redesigned in several different ways. The phase shifter 122 could be used for either the fundamental or the second harmonic. If the matching networks and filters were changed, the frequency doubler could also be replaced by a frequency divider. It would be also possible to add RF voltages for other harmonics by adding more phase shifters and including more frequency multipliers or dividers. It would also be possible to envisage a system where only a single matching network is used. The RF voltage generator could be replaced by a generator that produces an arbitrary waveform. This waveform would then pass through a single broad band RF amplifier and then through a single impedance matching network. Most likely the impedance matching network would need to have a very low Q for this to work. The transfer of energy to the plasma would not be efficient, but it would be possible.

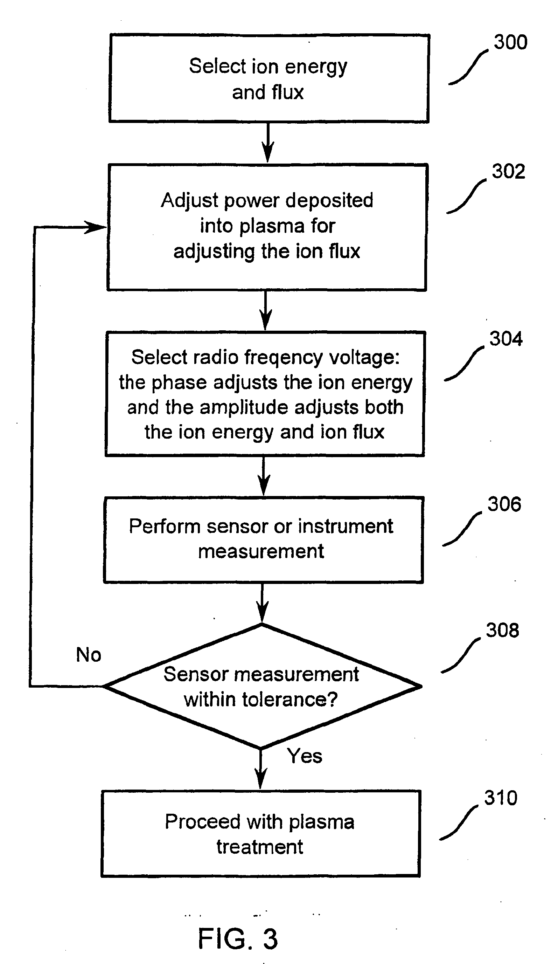

Fig. 3 shows a flow diagram of an embodiment of a method for performing the invention. The first step would be to select the ion energy and flux 300. The next step would be to adjust the total power absorbed by the plasma 302. The way that the power is absorbed by the plasma depends upon the mechanism for generating the plasma. Also, the RF power applied to the electrodes contributes to the power absorbed by the plasma. This additional power contributed by the electrodes should be taken into account when determining the ion flux. In general terms, the power absorbed into the plasma determines the ion flux. A radio frequency voltage is then selected which is used to adjust the ion energy 304. Changing the phase or the relative phase between two even harmonics changes the ion energy. Changing the amplitude of a harmonic component changes both the ion energy and the ion flux. In some situations the power and the radio frequency voltage would remain fixed during a plasma process. However, in some situations the plasma or the conditions necessary for the plasma treatment will change over time. In this case, a sensor could be used to measure some property of the plasma and be used to adjust the ion flux and ion energy dynamically. In this case the next step would be to perform a sensor or instrument measurement 306. Then either an operator or a controller would determine if the sensor measurement was within a specified tolerance 308. If the measurement is within tolerance then one would proceed with the plasma treatment 310. If not, then there would be a loop going back to adjusting the power 302 that is absorbed by the plasma and the same loop would repeat itself until the sensor was within tolerance. Then the plasma treatment would then proceed 310.

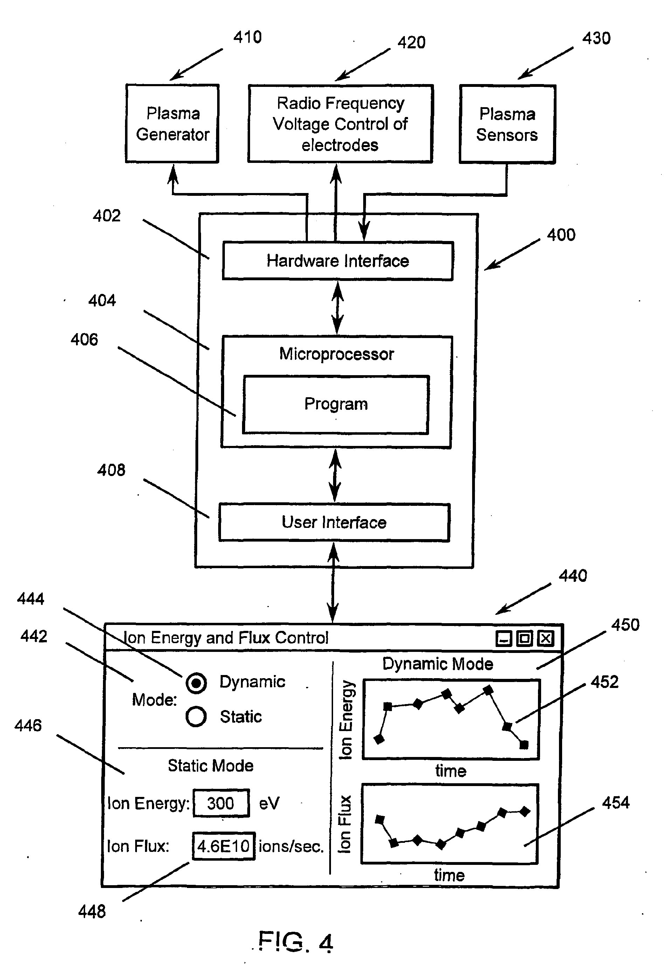

Fig. 4 is a schematic of an embodiment of a controller for automating the method of the invention. This figure shows the controller 400, a plasma generator 410, a radio frequency control for the voltage applied to the electrodes 420, values returning from the plasma sensor 430, and a dialogue box showing the ion energy and flux control 440. The control system 400 is comprised of a hardware interface 402, a microprocessor 404, a computer program product 406, which is executed by the microprocessor 404 and a user interface 408. An embodiment of the microprocessor could be a computer system.

The microprocessor 404 is connected to the hardware interface 402. The hardware interface 402 is connected to the plasma generator 410 and is able to control the amount of power absorbed by the plasma. The hardware interface is also connected to the radio frequency voltage control of the electrodes 420, and is used for controlling the voltage that is applied to the electrodes. The output of the plasma sensors 430 is also connected to the hardware interface 402. This data is used by the microprocessor 404 for adjusting the ion flux and energy. The microprocessor 404 is also connected to the user interface 408.

The user interface 408 is so that a user can control the ion energy and/or ion flux. Dialogue box 408 is a possible embodiment of a user interface. In this embodiment the system is able to be operated in two modes: either in dynamic mode or in static mode. In the static mode the ion energy and ion flux are set throughout the entire plasma treatment period. In the dynamic mode either or both the ion energy and the ion flux are able to have their values changed as a function of time. The dialogue box is divided into three regions. The first region is a region for selecting the operational mode 442. The second region is a region for controlling the ion energy and ion flux in the static mode of operation 446 and the third region is a region for dynamically controlling the ion energy and ion flux.

In the region for selecting the operational mode are two radio buttons 444. With these the user is able to select either the dynamic or the static mode. In the region for controlling the ion energy and ion flux in static mode 446 there are two text input boxes 448. Here the user is able to enter the ion flux and the ion energy. In the region for dynamically controlling the ion energy and ion flux 450, there are two input fields 454. These input fields 454 are used for setting either the ion energy or the ion flux as a function of time. This is accomplished by the user clicking and dragging the user adjustable controller 452. Normally when one operates a plasma operating apparatus the user would set values such as the power absorbed by the plasma or the power applied to the electrodes. This has the disadvantage that these parameters are not directly related to the resulting effect of the plasma treatment on the workpiece. An advantage of this system is that the user is able to directly control the ion energy and ion flux which is directly related to the effect of the plasma treatment on a workpiece.

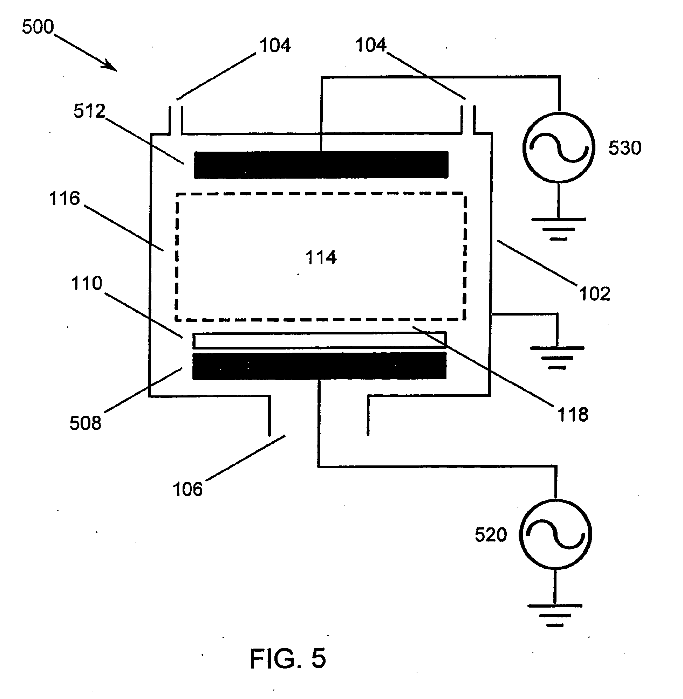

Fig. 5 shows a plasma operating apparatus with two capacitively coupled plasma sources 500. This is very similar to the plasma apparatus shown in fig. 1. The difference is that the grounded electrode is now connected to its own RF voltage system 530. This is called the second RF voltage system 530 and the essential difference is that an additional powered electrode has been added to the system. The RF voltage system 520 is connected to the powered electrode 508, a substrate or work piece is placed in front of the powered electrode 508. The substrate can also be placed in front of the second powered electrode 512. The second powered electrode is connected to the second RF voltage system 530. The embodiments of the RF voltage system 520 and the second RF voltage system 530 could be constructed in many different ways. The essential element is that at least two harmonic components of the applied RF voltage be even harmonics of each other and that there is a controlled relative phase between the two. This could be accomplished by having both of these harmonic components on RF voltage generator 520 or the second RF voltage 530. It is possible that RF voltage system 520 is operated in a mode where there is no phase locking with the second RF voltage system 530, or they could be operated in a phase locked manner.

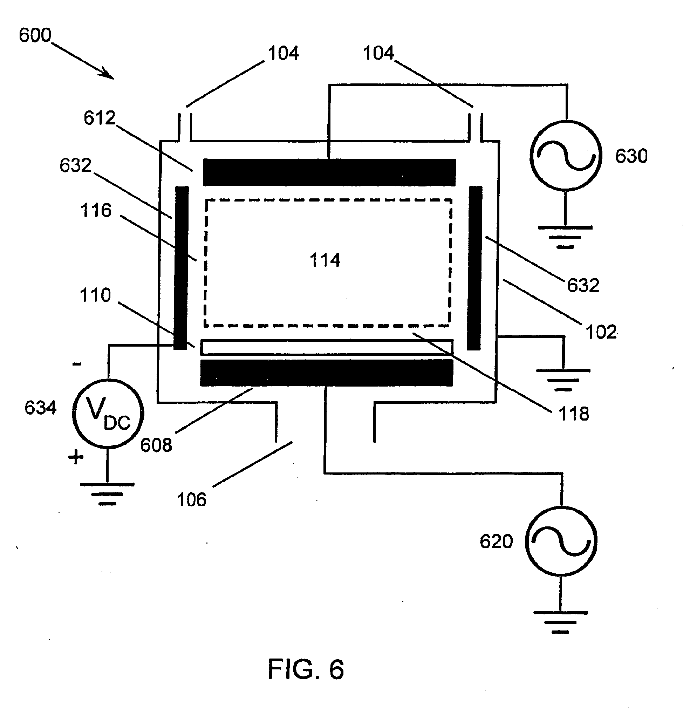

Fig. 6 shows a plasma operating apparatus with a DC/RF triode source 600. This is very similar to the capacitively coupled plasma source shown in fig. 5, except the addition of an additional DC electrode 632. This electrode 632 is connected to a DC power source 634. In this figure the RF voltage system 620 is connected to the powered electrode 608 and the second RF generator 630 is connected to the second powered electrode 612. Again, the substrate 110 is shown as being placed on the powered electrode 608. The substrate could also be placed upon the second powered electrode 612 or even the electrode 632 connected to the DC power source 634. Again, the RF voltage system 620 and the second RF voltage system 630 could have a variety of different examples. The two phase controlled even harmonics of the applied voltage could be applied entirely through RF voltage system 620 or through RF voltage system 630 or the two RF voltage systems could be operated in a phase locked manner.

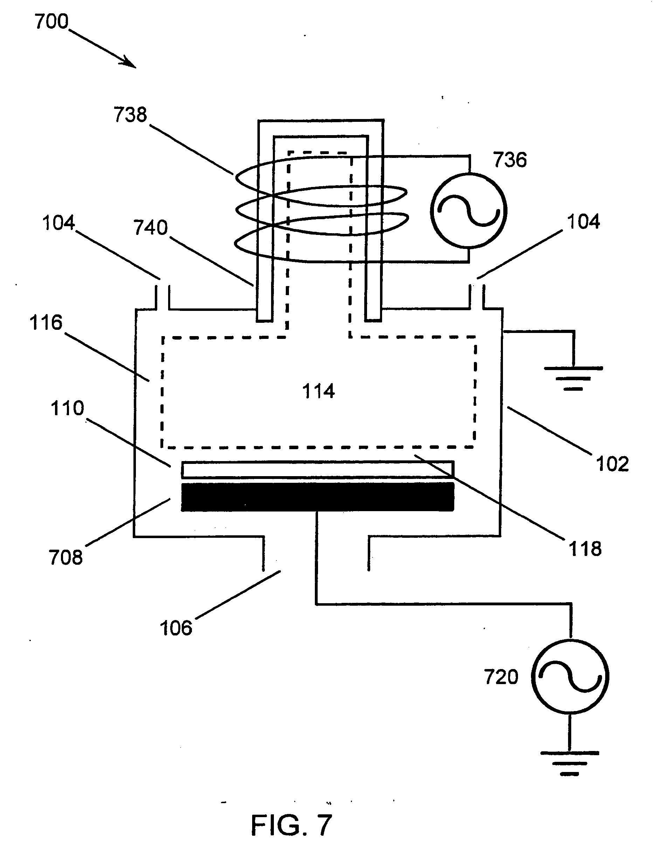

Fig. 7 shows a plasma operating apparatus with an inductively coupled plasma source 700. The basic structure of the plasma chamber is identical to previous examples, however the method of coupling power into the plasma and the primary method of generating the plasma is different. In this example an RF generator 720 is connected to the powered electrode 708. The substrate is placed on the powered electrode 708 and the vacuum chamber wall 102 functions as the second electrode. The RF current takes a path from the powered electrode 708 to the vacuum chamber wall 102. The second RF voltage system 736 is connected to a coil 738 which is shown as being wrapped around a dielectric tube 740 which is sealed at one end and has the other end open to the vacuum chamber 102. The RF power is coupled inductively to the plasma 114. For the inductively coupled source to function it is only necessary that a changing magnetic field is coupled to the plasma 114. The dielectric tube 740 could be replaced with a dome or a flat surface. The wafer or substrate could also be placed in the vicinity of the plasma chamber wall 102 to receive the benefit of the invention. The purpose of this figure is to show how the invention could be implemented in a radically different type of plasma operating apparatus. The advantage of using different types of plasma sources is that you would have different combinations of ion fluxes and ion energies available. In this example the embodiment of the RF voltage system 720 could be nearly identical to the RF voltage system 120 shown in fig. 1. It would also be possible to add additional electrodes to this system.

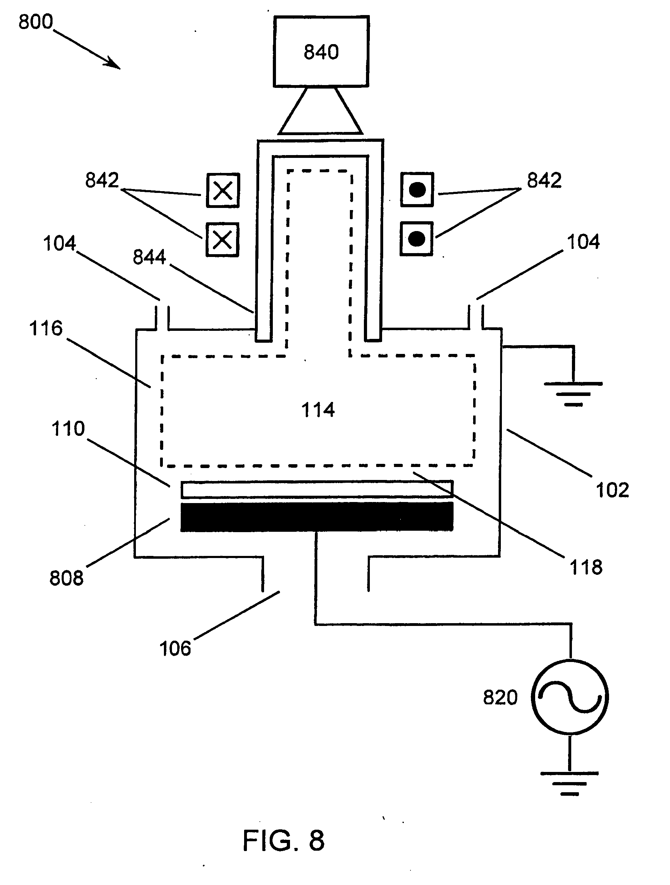

Fig. 8 shows an example included in a plasma operating apparatus with an ECR (Electron Cyclotron Resonance) plasma source 800. The basic structure of the vacuum chamber is very similar to the previous examples except that the main method of generating the plasma is different. The RF voltage system 820 is connected to the powered electrode 808. The RF voltage system 820 would be very similar to the RF voltage system 120 shown in fig. 1. The plasma is generated by directing a microwave source 840 towards a dielectric tube 844. A magnetic field is formed by coils 842 which are wound around the dielectric tube 844. Again, the dielectric tube is closed at one end and opens into the volume of the vacuum chamber. The plasma is generated inside the dielectric tube 844 and streams into the plasma chamber. Again the substrate could be placed adjacent to the vacuum chamber wall 102 instead of being placed upon the powered electrode 108.

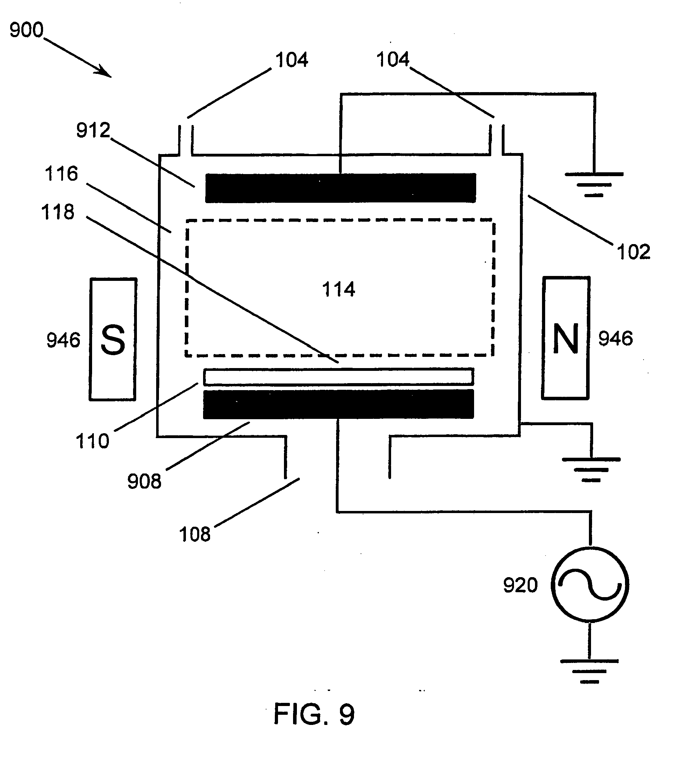

Fig. 9 shows a plasma operating apparatus with a magnetically enhanced capacitively coupled plasma source 900. This example is almost identical to that shown in fig. 1. The difference is that several magnets have been placed in proximity outside of the vacuum chamber wall to the powered electrode 908. The purpose of these magnets is that is slows the diffusion of electrons towards the electrode and enhances the plasma density within the vacuum chamber. The RF voltage system 920 is connected to the powered electrode 908. The substrate is placed upon the powered electrode 908. Again, the substrate or work piece could also be located in front of the grounded electrode 912. The ground electrode is connected to the ground. The magnets 946 are located outside the chamber wall 102 adjacent to the powered electrode 908. This is another example of how the invention could be applied to a conventional plasma operating apparatus. The RF generator 920 would be very similar or the same as the one shown in fig. 1.

The aspects shown in figure 1 and in figures 5 through 9 demonstrate the wide applicability of the invention. Embodiments of the invention can be implemented in other types of discharges that are not described. In particular, the invention can also be applied to NLD and helicon discharges.

**List of reference numerals**

| 100 | Plasma operating apparatus with a capacitively coupled plasma source |
| --- | --- |
| 102 | Vacuum chamber wall |

(continued)

| 104 | Gas inlet |
|-----|-----------|
| 106 | Vacuum pump outlet |
| 108 | Powered electrode |
| 110 | Substrate or work object |
| 112 | Grounded electrode |
| 114 | Plasma |
| 116 | Plasma sheath |
| 118 | Plasma sheath above the substrate |
| 120 | RF voltage system |
| 121 | RF voltage generator |
| 122 | Phase shifter |
| 123 | Frequency doubler |
| 124 | RF amplifier |
| 125 | RF amplifier |
| 126 | Impedance matching network |
| 127 | Impedance matching network |
| 128 | Low pass filter |
| 129 | High pass filter |
| 400 | Control system |
| 402 | Hardware interface |
| 404 | Microprocessor |
| 406 | Computer program product |
| 408 | User interface |
| 410 | Plasma generating system |
| 420 | Control unit of RF voltage system |
| 430 | Plasma sensor |
| 440 | Dialogue box for ion energy and ion flux control |
| 442 | Region for selecting operation mode |
| 444 | Radio buttons |
| 446 | Region for controlling ion energy and ion flux in static mode |
| 448 | Text input boxes |
| 450 | Region for dynamically controlling the ion energy and ion flux |
| 452 | User adjustable controller |
| 454 | Input field |
| 500 | Plasma operating apparatus with two capacitively coupled plasma sources |
| 508 | Powered electrode |
| 512 | Second powered electrode |
| 520 | RF voltage system |
| 530 | Second RF voltage system |

(continued)

| 600 | Plasma operating apparatus with a DC / RF triode source |
|---|---|
| 608 | Powered electrode |
| 612 | Second powered electrode |
| 620 | RF voltage system |
| 630 | Second RF voltage system |
| 632 | Electrode |
| 634 | DC voltage source |
| 700 | Plasma operating apparatus with an inductively coupled plasma source |
| 708 | Powered electrode |
| 720 | RF voltage system |
| 736 | Second RF voltage system |
| 738 | Coil |
| 740 | Dielectric tube |
| 800 | Plasma operating apparatus with an ECR plasma source |
| 808 | Powered electrode |
| 820 | RF voltage system |
| 840 | Microwave source |
| 842 | Coils to generate magnetic field |
| 844 | Dielectric tube |
| 900 | Plasma operating apparatus with a ME capacitively coupled plasma source |
| 908 | Powered electrode |
| 912 | Grounded electrode |
| 920 | RF voltage system |
| 946 | Magnet |

Appendix

## 1 Introduction

Capacitively coupled radio-frequency plasmas (RF-CCP) are applied to a wide range of different processes in industry, e.g. the manufacturing of semiconductor or the production of large area solar cell panels. The discharge is operated between two electrodes where typically the RF voltage is applied to one electrode and the counter electrode is on the same potential as the chamber wall, i.e. on ground. The applied voltage is mostly distributed over so called sheaths, the boundary region between the quasi-neutral plasma a and the electrode/wall. Within the sheaths, ions created in the plasma are accelerated towards the electrode. Therefore, the impinging energy is determined by the sheath voltage. In general, the high mass of the ions and the related inertia leads to an acceleration than is determined only by the RF period averaged mean voltage across the sheath, the so called RF bias. The ion energy is essential for the etching, deposition, or sputtering behavior. In parallel to accelerating ions the temporal oscillation of the sheath voltages leads also to an acceleration and related heating of electrons. Therefore, the production of the plasma is directly related to the frequency and amplitude of the RF voltage oscillation. Higher frequencies and higher voltage amplitudes lead directly to higher electron velocities and more efficient plasma production. On the other hard, the RF self-bias is reduced by applying higher $R_F$ frequencies.

Depending on the design of the chamber either the wall area is much larger than the electrode area (asymmetric discharges) or the areas are effectively identical (symmetric discharges). In the latter case the gap between the electrode and the counter electrode, which is on ground potential, is much smaller than the electrode radius, which gives the outer edge an ideally negligible influence. Symmetric discharges allow a minimum volume which provides better control of plasma chemistry due to more rapid gas exchange times. In case of large area applications, as e.g. solar cell panels, there are effectively

asymmetric discharge                    symmetric discharge

Figure 10: Schematic of the basic concepts of geometrically symmetric and asymmetric RF-CCP discharges.

no alternatives to symmetric conditions. While in asymmetric discharges the better part of the applied voltage is distributed across the sheath in front of the smaller electrode, in symmetric discharges also the voltage distribution is symmetric. Since the voltage control also the plasma production there is no independent setting of ion density and ion energy. In order to overcome this dilemma, in recent years so called dual-frequency discharges have found wide application, especially in the semiconductor industry. There, a high frequency RF voltage (typically several 10 MHz) together with a low frequency RF voltage (typically several MHz) is applied. While the high frequency contributes mainly to the plasma production, the lower frequency sets the bias. The two frequencies can be applied either in parallel to the same electrode or separately to the two electrodes. However, in symmetric discharges the effect on sheaths in front of both electrodes is still the same.

**2 Definitions**

If the frequency has a value of $f$, multiples of this frequency have values of $nf$, where $n = 2, 3, 4, 5, \cdots$. Even multiples of this frequency are defined to be frequencies $nf$, where $n$ can be factored by 2. Odd multiples are frequencies where $nf$ can not be factored by 2. When $n = 1$, the resulting frequency $f$ is referred to as the fundamental. Frequencies for values of $n > 1$ are referred to as harmonics. Frequencies which result front even multiples of the fundamental are referred to as even harmonic. The even harmonics are the frequencies $nf$ when $n = 2, 4, 6, 8, \cdots$. The odd harmonics are frequencies that result from odd multiples of the fundamental. Odd harmonics are frequencies $nf$ when $n = 3, 5, 7, 9, \cdots$. Harmonics take their name front the value of $n$. For example the frequency $2f$ is the second harmonic and $3f$ is the third harmonic.

**3 The Novel Concept**

Here, a. novel method is proposed that allows in geometrically symmetric discharges asymmetric sheath voltages and ion energies. This asymmetry is realized by applying in parallel two harmonic frequencies with a controlled relative phase, where the higher frequency must be an even multiple of the tower frequency. During a particular plasma process, the controlled relative phase could be held fixed. The effect is biggest for the combination of a given frequency with its second harmonic and both frequencies having the same amplitude. The ratio of the ion energies at both electrodes can be continuously varied by tuning the relative phase between the two frequencies. Thereby the ion energies can be either identical, being much large at one electrode than at the other or vice versa, or having any intermediate value. The theoretically maximum possible ratio is about three.

**4 Benefits of Embodiments of the Invention**

The asymmetry in the sheaths caused by adding an even harmonic has interesting consequences. This asymmetry causes a DC self bias that balances the ion and electron fluxes. As the asymmetry between the positive and negative portions of the applied voltage changes, the DC self bias will naturally adjust its self. This can be changed by adjusting the amplitudes of the individual frequency components, and it can also be accomplished by adjusting the phase between the applied voltages.

Adjusting the phase is extremely powerful. As the phase is changed, the RMS voltage applied to the discharge stays the same. The plasma parameters will change as the phase changes, but not as drastically as when the amplitudes of the harmonics are changed. As will be shown, the DC self bias on the electrodes will change greatly. This gives one the ability to adjust the ion energy to the electrodes. In fact, one can choose to increase or decrease the ion energy. As the ion energy impacting one electrode is increased the other is decreased. This also means that the roles of the two electrodes can be reversed electrically.

Currently, many reactive ion etchers use asymmetric plasmas chambers to generate a DC bias. This requires that the chamber be much larger than the substrate being etched. Using this technique for controlling the ion energy, the chamber could be made smaller. With a smaller plasma volume, this would reduce the amount of energy needed to generate the discharge. Electricity is the single largest cost of manufacturing integrated circuits. This technique would also allow smaller amount of possibly expensive and possibly toxic gases to be used. The overall effect would be to reduce the coast and environmental impact of manufacturing integrated circuits.

It is important to note that this technique will also allow the adjustment of the DC self bias in asymmetric discharges. There are also a large number of existing symmetric discharges, such as large area discharges for manufacturing solar panels or displays, that could be retrofitted with an embodiment of this invention. In both cases, existing plasma chambers could easily be outfitted with new rf power supplies and matching networks. Only the symmetric case is considered in this work. The DC self bias and hence the ion energy is most adjustable for symmetric discharges.

Many commercial discharges are generated by means other than by a capacitive discharge. Common examples would be discharges generated by inductively coupled sources or microwave sources. It is also common for these discharges to have an additional capacitive electrode, upon which a substrate can be placed. These discharges use the DC self bias caused by the in-equal areas of the electrode and the chamber wall. This causes a DC self bias which accelerates ions towards substrates placed on the capacitive electrode. Embodiments of the invention described in this report could also be used to modify the ion energy in this situation. Since described embodiments of the invention are only electrical in nature, an embodiment of the invention could easily be retrofitted to any chamber that uses a capacitive electrode or electrodes to modify the ion energy.

It should also be noted that it is possible to add more than one even harmonic to achieve the same effect. The requirement for an symmetric sheath is that the applied voltage be symmetric. Arbitrary asymmetric voltage waveforms can be constructed by adding their individual Fourier components.

Later in this report it is shown with both the analytical model and the Brinkmann sheath model that the DC self bias and hence the mean ion energy changes nearly linearly with the change in the phase angle between the fundamental and the second harmonic. This allows very precise control and adjustment of the ion energy striking the surface.

Figure 11: This figure shows one way in which an embodiment of the invention could be implemented.

## 5 Application of Embodiments of the Invention

Embodiments of the invention can be used for a variety of applications. Essentially it will be useful whenever one would like to be able to independently adjust the number and energy of ions striking a substrateexposed to a plasma. Applications include, but are not limited to: etching plasmas (e.g. semiconductors), deposition plasmas (e.g. solar cells) , and plasmas used For surface modifications (e.g. polymer activation).

### 5.1 Representative Design

Fig. 11 shows a diagram of one possible embodiment of the invention using standard RF components. This figure is intended to represent a possible embodiment of the invention using standard RF electronic components. There are many other alternate and modified designs that can achieve the same result and are obvious for experts in the field. Embodiments of the invention are not intended to be limited to this design.

In this example, a single RF frequency function generator is used to create a single RF frequency. In this case, the RF generator is set to the fundamental frequency desired. The RF signal is then split in two. This can also be done using standard RF components. One signal is fed into a frequency doubler. This generates the second harmonic. The other signal is fed into a phase shifter. The phase shifter is used to control the relative phase of the two signals. Each of these signals is then fed into its own Ref amplifier. Each having its own amplifier, the output amplitude of the fundamental and the second harmonic are independently adjustable. After each amplifier, a matching network is attached to each. The matching networks adjusts the impedance of the each signal to maximize the power delivered by each to the plasma. Finally, the high and low frequency RF electronics are isolated from each other using high and low pass filters.

### 5.2 Plasma Processing of Large Substrates

A major application of embodiments of this invention would be in the processing of large substrate in plasmas. An example would be the large dielectric substrates used for manufacturing solar panels. They can be several square meters in surface area. An example is the Leybold Optics linear Cluster-System PHOEBUS for production of large scale solar panels. The ion energy striking a surface has a large effect during etching processes, and can effect the quality and properties of thin films and surfaces in contact during plasma processing. There are currently two methods used for modifying the ion energy in plasmas. The first is the geometrically based DC self bias effect. This is not able to be used for large substrates, because the plasma chamber dimensions would become too large. Therefore, these discharges are basically all symmetric. The second technique is to apply two or more RF frequencies. One is a very low frequency and the other is much higher, and the two frequencies are not phase locked. The problem with this technique is that as the frequency become higher and the dimensions of the substrate become larger, there will be standing RF waves inside the chamber. Using an embodiment of the invention, both frequencies could be kept lower and standing waves could be avoided.

### 5.3 Retrofitting of Existing Equipment

There exist a large number of plasma reactors with either use capacitive electrodes for generating a plasma. These existing chambers could be easily retrofitted to use an embodiment of this invention. An example of such a system is the Lam Research Exelan high performance dielectricetch system. This is a symmetric, capacitively coupled plasma reactor used for etching processes in the semiconductor industry. The Lam Exelan applies 2 MHz and 27 MHz RF power to a single electrode. The two frequencies are not phase locked. This etching tool would benefit from and could be retrofitted with an embodiment of the invention. This would involve removing the existing RF generators and matching networks and replacing them with a new RF power system. Since embodiments of the invention control the ion energy by a purely electrical means, there would be no need to modify the actually plasma chamber and electrode. The electronics need only be replaced.

There also exists large number of plasma reactors that are generated by other means. Examples would be plasmas produced by inductively coupled antennas or the microwave generation of plasmas. It is also common for these plasmas to have an additional capacitive electrode for the coupling of RF power into the discharge. The additional electrode acts as one electrode and the chamber wall acts as the other electrodes. Typically the wall has a much larger surface area than the electrode. This in-equal area will cause a DC self bias to develop which will cause the acceleration of ions towards the substrate resting upon the electrode. An embodiment of the invention could also be used to adjust the ion energy striking the surface. As with plasmas generated exclusively by capacitive means, these other plasma chambers could by retrofitted by replacing the RF electronics used for powering the capacitive electrodes. An example of a commercial chamber that could be modified is the Applied Materials DPS plasma reactor. The plasma is generated using a inductive antenna mounted on a dielectric dome. A capacitive electrode is mounted beneath for modifying the ion energy to the substrate. The RF electronics for the capacitive bias could be replaced.

**6 Basic physical model**

**6.1 The Origin of the Asymmetry**

The RF potential applied to the discharge is $\phi(\varphi)$, where $\varphi = \omega t$ is the fundamental phase. $\phi(\varphi)$ can be represented as a superposition of various harmonic frequencies $n\omega$ with arbitrary amplitudes $a_n$ and $b_n$, where $n$ is an integer ranging from 1 to a maximum number $N$ and $\omega$ is the fundamental frequency:

$$\phi(\varphi) = \sum_{n=1}^{N} [a_n \sin(n\varphi) + b_n \cos(n\varphi)] \tag{1}$$

In order to have symmetric voltage waveforms at the sheaths at both electrodes, the applied RF voltage waveform must be an anti-symmetric with respect to some reference phase $\varphi_0$:

$$\phi(\varphi - \varphi_0) = -\phi\left(-(\varphi - \varphi_0)\right) \tag{2}$$

The reference phase has to be chosen so that $\varphi_0 = m\pi/N$, where m is an integer within the range $1 \leq m \leq N$. The above anti-symmetry condition is fulfilled in the following cases:

(a) In case of only sine-terms ($b_n = 0$) $\varphi_0 = 0$ is always a common reference phase of anti-symmetry for all frequencies and symmetric sheath voltage are obtained.

(b) In case of only cosine-terms ($a_n = 0$) a common reference phase of anti-symmetry for all frequency terms is always found if only odd higher harmonics are present.

(c) The same applies for a combination of (a) and (b), i.e. odd harmonics in the cosine terms and any harmonics in the sine terms.

On the other hand, in case of a symmetric waveform, the sheath voltages become asymmetric:

$$\phi(\varphi - \varphi_0) = \phi\left(-(\varphi - \varphi_0)\right) \tag{3}$$

This condition is fulfilled in the following cases:

(a) In case of only cosine-terms ($a_n = 0$) ($\varphi_0 = 0$ is always a common reference phase of symmetry for all frequency terms if only even higher harmonies are present.

(b) In case of odd harmonics in the sine term and even harmonic in the cosine term a common reference phase of symmetry can be found.

It should be noted that the fundamental frequency (n=1) is always an odd term. In the simplest case, therefore, the cosine-term at the second harmonic is combined with either a sine or a cosine term at the fundamental frequency. Introducing a general phase shift in the fundamental frequency allows tuning between extreme cases where the applied waveform has ether a much higher negative or positive amplitude or becomes anti-symmetric. More complex cases can be realized by a Fourier composition of the waveform with more than two frequencies.

**6.2 Graphical Explanation of the Effect**

Figure 12: Plot of the function $V_{AC}(t) = 315\,(\cos(2\pi ft) + \cos(4\pi ft))$ for two rf periods, where $f = 13.56\,\mathrm{MHz}$. This function is composed of two function which are symmetric about the x axis, but the sum of the two functions is not. The voltage across the two sheaths will therefore be different. This asymmetry in the applied voltage leads to an asymmetry in the sheaths and a DC voltage offset in the two sheaths.

The basins of the effect is explained again graphically. In subsequent sections, a simple analytical model will be used to explain the effect in more detail and the Brinkmann sheath model will be used to calculate the effect even more accurately. The sheath model will illustrate that this effect is self-amplifying. As one sheath has a. larger voltage relative to the other, the average ion density drops in the former sheath. This will be shown to cause an additional increase in the DC self bias effect.

The bulk of the plasma has a impedance that is very small in comparison to the impedance of the sheaths. In the next section a simple analytical model is developed which assumes a quadratic charge voltage relationship for the sheaths any neglects the impedance of the plasma bulk.

A model like this is able to model the non-linear electrical properties of a capacitive discharge well. Because the impedance of the plasma bulk is neglected, the voltage across the discharge can essentially be divided between the two sheaths. Fig. 12 shows graphically why adding a second harmonic will result in asymmetric sheaths in even a symmetric discharge. In this figure, the voltage:

$$V_{AC}(t) = 315\,(\cos(2\pi ft) + \cos(4\pi ft)) \tag{4}$$

is plotted, where $f$ = 13.56 MHz. $V_{AC}$ is considered to be the AC voltage applied to

Figure 13: Plot of the function $V_{AC}(t) = 315\,(\cos{(2\pi ft + \Theta)} + \cos{(4\pi ft)})$ for different values of the phase angle $\Theta$. This figure illustrates that the asymmetry of the applied voltage, and hence that the asymmetry of the two sheaths can be controlled by the phase angle.

a discharge. The DC self bias builds up naturally and will be considered later in the chapter. Each of the two cosine functions are symmetric about the x-axis, but the sum of the two is not. Above the axis there is one maximum per rf cycle, and below the axis there are two minimums per rf cycle. The sheaths on the two electrodes produced by this applied voltage will very clearly not be symmetric. A DC bias will necessarily need to build up to balance the charged particle fluxes to the two electrodes. This is the basis of the effect.

The ability of the phase to affect the DC bias can also be illustrated graphically. Fig. 13 shows plots of the function:

$$V_{AC}(t) = 315\,(\cos{(2\pi ft + \Theta)} + \cos{(4\pi ft)})\,, \qquad\qquad (5)$$

where $f$ = 13.56 MHz. It is obvious that the phases $\Theta = 0$ and $\Theta = \pi/2$ will lead to strongly asymmetric sheaths. The phases $\Theta = -\pi/4$ and $\Theta = \pi/4$ are still asymmetric, but as will be seen later in Fig. 22 lead to ion energy distributions (IED) that are nearly symmetric in both sheaths. Again the voltage waveforms in Fig. 13 are AC voltages and do not include the DC self bias.

The phase can be used to control the degree of asymmetry in the sheath and therefore the DC self bias produced by the effect. Additionally, looking at phases $\Theta$ ..... 0 and $\Theta$ .... $\pi/2$ we see that by simply changing the phase angle the roles of the two electrodes can be reversed electrically. The effect not only creates a controllable DC self bias, but it also allows the roles of the two electrodes to be reversed. Ion energies can be increased or decreased. This is in great contract to the conventional DC self bias effect which relies on the geometry of the discharge and is not reversible.

In the examples presented in this chapter, the fundamental and the second harmonic are always chosen. There will be an asymmetry in the two sheaths whenever an even harmonic in included, but the effect is largest when it is simply the fundamental and the second harmonic.

## 7 Analytical Model

The self bias effect will be studied with a simple analytical model that is originally due to Czarnetzki [1]. This model solves the non-linear electrical equations by using the so-called matrix sheath. The ion density is considered to be constant within each sheath and the electron density is a step function. In this case, the sheath has a quadratic charge-voltage relationship. All of the quantities in the model are dimensionless and normalized.

In the version of the model presented here, the total voltage across the discharge, $V_{total}$, is transformed into the normalized voltage across the entire discharge, ø:

$$\phi = \eta + \tilde{\phi}(\varphi), \tag{6}$$

where $\eta$ is the normalized and dimensionless DC self bias, $\varphi$ = wt, and $\tilde{\varphi}(\varphi)$ is the normalized and dimensionless AC voltage applied to the discharge. $\tilde{\varphi}(\varphi)$ is the voltage applied by the rf generator. Normally capacitively coupled discharges are electrically isolated from the generator by one or more blocking capacitors contained in the matching network. The DC self-bias, $\eta$ builds up naturally to balance charged particle fluxes.

By neglecting the impedance of the plasma bulk, the voltage across the entire discharge can be considered to be the sum of the voltage drop across the two sheaths:

$$\phi = \phi_{se} + \phi_{sg}, \tag{7}$$

where $\phi_{se}$ is the voltage drop across the powered electrode's sheath and $\phi_{sg}$ is the voltage drop across the grounded electrode's sheath. Using the matrix sheath model to express the voltages across the sheath, we have:

$$\phi_{se} = -q^2 \tag{8}$$

and

$$\phi_{sg} = \epsilon(q_t - q)^2 \quad \text{where} \quad \epsilon = \frac{\overline{n}_{se} A_{se}^2}{\overline{n}_{sg} A_{sg}^2}. \tag{9}$$

$q$ is the charge in the powered sheath, $q_t$ is the total charge in both sheaths, $n_{se}$ is the average ion density in the sheath of the powered electrode, $n_{sg}$ is the average ion density in the grounded electrode, $A_{se}$ is the area of the powered electrode, and $A_{sg}$ is the area of the grounded electrode. $\epsilon$ is a factor used to account for differences in the area of the electrode and in the average ion density in the sheath. In a geometrically symmetric discharge both are a identical, but the ion densities can deviate due to asymmetric sheath voltages.

Combining Eqs. 7 to 9:

$$\phi = -q^2 + \epsilon(q_t - q)^2. \tag{10}$$

The extremums of Eq..10 can be found by assuming that at an extremum the charge in one of the sheaths goes to zero. For Eq. 10, this happens when $q = 0$ and when $q = q_t$. Substituting this into Eq. 10, this gives two voltage extremums $\phi_{m1}$ and $\phi_{m2}$, where $\phi_{m2} < \phi_{m1}$:

$$\phi(\varphi_{m1}) = \phi_{m1} = \epsilon q_t^2 \quad \text{when} \quad q = 0 \tag{11}$$

$$\phi(\varphi_{m2}) = \phi_{m2} = -q_t^2 \quad \text{when} \quad q = q_t \tag{12}$$

Substituting these extremums into Eq. 6, $\eta$ and $q_t$ can be solved for in terms of $\phi_{m1}$ and $\phi_{m2}$.

$$\eta = -\frac{\tilde{\phi}_{m1} + \epsilon\tilde{\phi}_{m2}}{1 + \epsilon} \tag{13}$$

$$q_t = -\left(\frac{\tilde{\phi}_{m1} - \epsilon\tilde{\phi}_{m2}}{1 + \epsilon}\right)^{\frac{1}{2}} \qquad (14)$$

Using the quadratic equation, Eq. 10 can be solved for $q$:

$$q = \frac{\epsilon q_t + \sqrt{\epsilon q_t + (\epsilon - 1)\phi}}{\epsilon - 1} \qquad (15)$$

Figure 14: Solutions to Eq. 20.

This equation, by substituting Eq. 14, becomes in the limit of $\epsilon$ approaching 1:

$$q = -\frac{|q_t|}{2}\left(1 - \frac{\phi}{|q_t|^2}\right) \qquad (16)$$

The largest DC self bias occurs when the fundamental and the second harmonic are used. Using a fundamental and second harmonic of equal amplitude, the applied AC voltage is:

$$\tilde{\phi}(\varphi) = \frac{1}{2}\cos(\varphi + \Theta) + \frac{1}{2}\cos(2\varphi), \qquad (17)$$

The total voltage drop across the discharge is then:

$$\phi = \eta + \frac{1}{2}\cos(\varphi + \Theta) + \frac{1}{2}\cos(2\varphi), \qquad (18)$$

where $\Theta$ is the phase angle between the two wave forms. The extremum of this equation can be found by taking the derivative with respect to $\varphi$ and setting the result to zero:

$$\sin(\varphi_m + \Theta) + 2\sin(2\varphi_m) = 0 \qquad (19)$$

Eq. 19 does have an analytical solution. Unfortunately, it is so complicated that the result is not useful. Instead, it is easier to give the inverse relation in an implicit form:

$$\Theta = \begin{cases} -\varphi_m + \arcsin\left(-2\sin(2\varphi_m)\right) \\ -\varphi_m - \arcsin\left(-2\sin(2\varphi_m)\right) \pm \pi \end{cases} \qquad (20)$$

Figure 15: This figures show how $\phi_{m1}$ and $\phi_{m2}$ are constructed from Eqs. 23 through 26.

Fig. 14 shows solutions to the Eq. 20 By examining this figure and Eq. 20, it can be seen that all of the solutions for $\varphi_m$ are within the range:

$$|\varphi_m| \leq \frac{\pi}{12} + n\frac{\pi}{2} \quad \text{where} \quad n = 0, 1, 2, \cdots \qquad (21)$$

This relation is used to calculate approximate values of $\tilde{\varphi}_{m1}$ and $\tilde{\varphi}_{m2}$. As indicated by the dashed lines in Fig. 14 we can see that:

$$\varphi_m \approx 0, \pm\frac{\pi}{2}, \pm\pi, \cdots \qquad (22)$$

This approximation can be used to approximate $\phi_m$. Substituting the approximation for $\tilde{\varphi}_m$ into Eq. 17

$$\tilde{\phi}_m = \frac{1}{2}\left(\cos(\Theta) + 1\right) \quad \text{when} \quad \varphi_m = 0 \qquad (23)$$

$$\tilde{\phi}_m = \frac{1}{2}\left(-\sin(\Theta) - 1\right) \quad \text{when} \quad \varphi_m = \frac{\pi}{2} \tag{24}$$

$$\tilde{\phi}_m = \frac{1}{2}\left(\sin(\Theta) - 1\right) \quad \text{when} \quad \varphi_m = -\frac{\pi}{2} \tag{25}$$

$$\tilde{\phi}_m = \frac{1}{2}\left(-\cos(\Theta) + 1\right) \quad \text{when} \quad \varphi_m = \pi \tag{26}$$

Other values do not need to be considered, because the approximation is cyclical when substituted into Eq. 17. Plotting these four functions, together it is easily seen how to

Figure 16: Plot of the approximate value of $\eta(\Theta)$ as given by Eq. 29.

construct the maximum, $\phi_{m1}$; and minimum, $\phi_{m2}$, voltages. The maximum voltage is:

$$\phi_{m1} = \begin{cases} \frac{1}{2}(1 + \cos(\Theta)) & : & -\frac{\pi}{2} \leq \Theta \leq \frac{\pi}{2} \\ \frac{1}{2}(1 - \cos(\Theta)) & : & \frac{\pi}{2} \leq |\Theta| \leq \pi \end{cases} \tag{27}$$

and the minimum voltage is:

$$\phi_{m2} = \begin{cases} \frac{1}{2}(-1 - \sin(\Theta)) & : & 0 \leq \Theta \leq \pi \\ \frac{1}{2}(-1 + \sin(\Theta)) & : & -\pi \leq \Theta \leq 0 \end{cases} \tag{28}$$

A further approximation, setting $\epsilon = 1$ is made. This allows an approximate calculation of $\eta$ and $q_t$. This is identical to assuming that the two areas and ion densities are equal. Using the assumption that $\epsilon = 1$, Eq. 10 becomes:

$$\eta = -\frac{1}{4}\begin{cases} -\cos(\Theta) + \sin(\Theta) & : & -\pi \le \Theta \le -\frac{\pi}{2} \\ \cos(\Theta) + \sin(\Theta) & : & -\frac{\pi}{2} \le \Theta \le 0 \\ \cos(\Theta) - \sin(\Theta) & : & 0 \le \Theta \le \frac{\pi}{2} \\ -\cos(\Theta) - \sin(\Theta) & : & \frac{\pi}{2} \le \Theta \le \pi \end{cases} \qquad (29)$$

Figure 17: This figure shows that $q_t$ is nearly constant as the phase angle $\Theta$ is changed. There are only minor changes in the discharge as $\Theta$ is changed.

Fig. 29 shows a plot of Eq. 29 this shows that $\eta$ varies close to lineary. As a result the mean ion energy striking an electrode will also varies close to linearly as $\Theta$ is changed. This would allow very precise control of the ion energies.

When $\Theta$ is zero, it can be shown that

$$\eta = -\frac{7}{32} \qquad (30)$$

Transforming $\eta$ back into normal coordinates:

$$V_{DC} = 2 V_0 \eta = 2 \cdot 315\,V \cdot \frac{7}{32} = 137.80\,V \qquad (31)$$

In the frame of the above approximation the total change is $q_t$ is basically independent of the phase angle. This is shown in Fig. 17. $q_t \approx -0.92$.

The analytical model can also be used to explicitly calculate the voltages across the individual sheaths. Fig. 18 shows this when $\Theta = 0$. The good agreement between the simple analytical model and the simulation is achieved by using the correct value for e as resulting from the simulation. Although this parameter is not calculated self consistently

Figure 18: This figure shows the individual sheath voltages and $\eta$ calculated by the analytical model. $\Phi$ is the total applied voltage, $\Phi_g$ is the voltage across the ground electrode, and $\Phi_e$ is the voltage across the powered electrode.

within the analytical model it shows that the physical picture behind the model is correct. Therefore, the asymmetry in the sheath voltages causes also an asymmetry in the sheath densities which then further amplifies the effect of asymmetric sheath voltages. This finally makes the technique even more effective.

## 8 Monte-Carlo simulations of Ion Energy Distributions

In this section the sheath model of Brinkmann [2] is used to calculate the DC self bias and to construct construct a simple ion Monte-Carlo simulation to verify that the ion energy can be controlled. A discussion of the development of the code is contained in Section 8. This simulation is nearly identical with the procedure applied by Wild and Koidal [3].

The plasma parameters used for this simulations described in this section were taken from experimental data published by Godyak, Piejak, and Alexandrovich |4|. The experimental parameters described in this reference for the 20 mTorr case in Fig. 18 were used. Quantities such as the electron temperature and electron density were obtained by digitizing the EEPF (Electron Energy Probability Function) in Fig. 18 and extracting the data. Instead of using a single, sinusoidal frequency, the applied voltage waveform

Figure 19: The total voltage across the discharge, $V_{total}(t)$, calculated by the Brinkmann model when applied AC voltage is given by Eq. 5 when $\Theta = 0$. The voltage across the grounded sheath is $V_g$ and the voltage across the powered sheath is $V_p$.

Figure 20: The DC self bias, $V_{DC}$, as a function of $\Theta$ when the sinusoidal applied voltage has been replaced with Eq. 5. Apart from the voltage, the simulation parameters are taken data digitized from the 20 mTorr experiment of Fig. 18 in Reference [4].

used is Eq. 5. The amplitude of this waveform has been chosen so that its RMS value is equal to the RMS voltage of the original single frequency experiment. The IED at both electrodes was calculated for a variety of different values of $\Theta$.

The sheath model of Brinkmann can also be used for determining the DC self bias. Fig. 19 shows the total voltage applied to the discharge, $V_{total}(t)$; the voltage across the powered electrode's sheath, $V_p(t.)$; and the voltage across the grounded electrode's sheath, $V_g(t)$ when $\Theta = 0$. The DC self bias, $V_{DC}$, in this case is -221 V. The DC self bias predicted by the simple analytical model for a $V_0$ of 315 V was -137.8 V. The main difference between the two models is that in the analytical solution it was assumed that the ion densities in the sheaths are identical ($\epsilon = 1$), was constant. In the next section the ion densities at the sheath edges are used to estimate $\epsilon$ and a much closer prediction by the two models is made.

Fig. 20 shows the DC self bias as a function of Θ. What can be seen in this figure is that the DC self bias for the caste investigated can be linearly adjusted by the phase angle. Additionally there is a large change in the DC self bias. IDFs for the extremums of the DC self bias, Θ = 0 and Θ = π/2 are calculated; as well as for when the DC self bias is 0 at, Θ = -π/4 and Θ = π/4.

The electric fields for the ion Monte-Carlo simulation are calculated using the Brinkmann model, and as in Wild and Koidal's original paper only change exchange collisions are considered. Adding elastic collisions between ions and neutral atoms would make the simulation more realistic, but would add substantial computational complexity. The present simulation in intended to demonstrates that even in the pretence of collisions this effect is observable and the ability of this effect to adjust ion energies. It can be expected that the effect of elastic collisions would be basically a flattening of the structures in the spectra.

When Θ = 0, the IED at the powered electrode is shown in Fig. 21-A, and the IED at the grounded electrode is shown in Fig. 21 - B. If Θ is adjusted so that Θ = π/2, then the situation is reversed. Fig. 21-B then shows the IED at the powered electrode and Fig. 21 - A shows the IED at the grounded electrode.

Similarly when Θ = -π/4, the IED at the powered electrode is shown in Fig. 22-A, and the IED at the grounded electrode is shown in Fig. 22-B. If Θ is adjusted so that Θ = π/4, then the situation is again reversed. Fig. 21-B then shows the IED at the powered electrode and Fig. 21-A shows the IED at the grounded electrode. Figs. 21 and 22 demonstrate the adjustability of the IEDs using the DC self bias effect.

The Brinkmann model can also be used to calculate charged particle densities in the sheath. Fig. 23 shows the time averaged ion densities for the two sheaths that correspond to the two IEDs shown in Fig. 21. Sheath A matches with Fig. 21-A and sheath B matches with Fig. 21-B. These densities are used in the next section to calculated ∈ for

Figure 21: IED distributions shown for when Θ = 0 and Θ = π/2 for the total discharge voltage specified in Eq. 5. When Θ = 0, A is the IED for the powered electrode and B is the IED for the grounded electrode. When Θ = π/2, B is the IED for the powered electrode and A is the IED for the grounded electrode. The shaded region shows the fraction of the IED that is due to ions that underwent an ion exchange collision before reaching the electrode.

Figure 22: IED distributions shown for when $\Theta = -\pi/4$ and $\Theta = \pi/4$ for the total discharge voltage specified in Eq. 5. When $\Theta = -\pi/4$, A is the IED for the powered electrode and B is the IED for the grounded electrode. When $\Theta = \pi/4$, B is the IED for the powered electrode and A is the IED for the grounded electrode. The shaded region shows the fraction of the IED that is due to ions that underwent an ion exchange collision before reaching the electrode.

Figure 23: This figure shows the time averaged ion densities calculated by the Brinkmann model for the sheaths corresponding to the IEDs shown in Fig. 21. Sheath A matches with Fig. 21−A and sheath B matches with Fig. 21−B.

the analytical model.

In the section the estimate of the DC self bias calculated by the analytical model is improved by using the charged particle densities calculated by the Brinkmann model.

Again the extremums can be found by setting $q = 0$ and $q = q_t$. The voltage equations are the same as before.

$$\eta + 1 = \eta q_t \tag{32}$$

and

$$\eta - \frac{9}{16} = -q_t \tag{33}$$

solving for $\eta$:

$$\eta = \frac{\frac{9}{16}\epsilon - 1}{1 + \epsilon} \tag{34}$$

From Fig. 23 the ion densities of A and B are $4.701 \cdot 10^{14}$ m$^{-3}$ and $6.483 \cdot 10^{14}$ m$^{-3}$. Using these densities, $\epsilon$ becomes:

$$\epsilon = \frac{n_1 A_1^2}{n_2 A_2^2} = \frac{4.701 \cdot 10^{14}}{6.483 \cdot 10^{14}} \approx 0.725 \tag{35}$$

Figure 24: Sheath voltages calculated with the analytical model using $\epsilon = 0.725$. The normalized results were scaled by a factor of 1 being equal to 628 V.

Substituting this value of $\eta$ into Eq. 34, we see that $\eta$ is:

$$\eta \approx -0.34322 \tag{36}$$

Transforming η back into normal coordinates:

$$V_{DC} = 2 V_0 \eta = 2 \cdot 315\,V\,(-0.34322) = -216.21\,V \qquad (37)$$

The sheath voltage calculated using the analytical model can also be improved using this value of $\epsilon$. The various voltages displayed in Fig. 24 show very good agreement with the numerical simulation.

**References**

[1] U. Czarnetzki, T. Mussenbrock, and R. P. Brinkmann. Self-excitation of the plasma series resonance in radio-frequency discharges: An analytical description. Phys. Plasmas, 13:123503, 2006.

[2] Ralf Peter Brinkmann. Beyond the step model: Approximate expressions for the field in the plasma boundary sheath. J. Appl. Phys., 102:093303, 2007.

[3] C. Wild and P. Koidl. Ion and electro dynamics in the sheath of radio-frequency glow discharges. 69(5):2909-2922, Mar 1991.

[4] V. A. Godyak, R. B. Piejak, and B. M. Alexandrovich. Measurements of electron energy distribution in low-pressure rf discahrges. Plasma Sources Sci. T., 1:36-58, 1992.

**Claims**

1. A method of adjusting a DC self-bias in front of electrodes (102, 106, 108, 112, 508, 512, 608, 612, 632, 708, 808, 908, or 912) in a plasma operating apparatus (100, 500, 600, 700, 800, or 900) by applying an RF voltage with at least two harmonic frequency components with a controlled relative phase between the components, where at least one of the higher frequency components is established as an even multiple of the lower frequency component, wherein the DC self-bias of the sheaths between the plasma and the electrodes is linearly adjusted by tuning the relative phase.

2. The method of claim 1, wherein the DC self-bias is dynamically controlled by varying the relative phase between the harmonic components of the applied voltage and/or by varying the amplitudes of the harmonic components of the applied voltage.

3. The method of claim 1 or 2, wherein the relative phase of the harmonic component of the applied voltage is fixed.

4. The method of claims 1 or 3, wherein the amplitudes of the harmonic components of the applied voltage is fixed.

5. The method of any one of the proceeding claims, wherein the at least two harmonic frequency components with a controlled relative phase of the RF voltage are applied to one electrode.

6. The method any one of the proceeding claims, wherein one of the higher frequency components of the applied voltage is the second harmonic of the lower frequency.

7. The method of any one of the proceeding claims, wherein the ratio of the ion energies at the electrodes is varied by tuning the relative phase between the at least two frequencies.

8. The method of any one of the proceeding claims, wherein the relative phase is used to control the degree of asymmetry in the sheaths between the plasma and the electrodes to increase or decrease the ion energy.

9. The method of any one of claims 1 through 8, wherein the plasma is generated by the RF voltage which also establishes the DC self-bias (100, 500, 600, or 900).

**10.** The method of any of the proceeding claims, wherein the plasma is used for surface modification, for thin film deposition, for plasma etching, for plasma etching of dielectric substrates, for the manufacture of semiconductor devices, micro electro mechanical systems (MEMS) devices, solar cell (photovoltaic) panels, or flat screen television displays, for the sputtering of surfaces, gas phase surface modification, surface cleaning, controlling surface energies, improving biocompatibility, the promotion of adhesion, manufacture of nanoparticles, the assembly of nanoparticles into structures or devices, and/or the surface cross linking of polymers.

**11.** The method of any one of the preceding claims, wherein an asymmetry in the plasma sheath region (116 or 118) causes the DC self bias.

**12.** The method of any one of the preceding claims, wherein one of the two or more electrodes is a wall (112) of a vacuum chamber and/or part of a vacuum pump (108).

**Patentansprüche**

**1.** Verfahren zum Anpassen einer DC-Eigenvorspannung vor Elektroden (102, 106, 108, 112, 508, 512, 608, 612, 632, 708, 808, 908 oder 912) in einer Plasmabetriebsvorrichtung (100, 500, 600, 700, 800 oder 900) durch Anlegen einer HF-Spannung mit mindestens zwei harmonischen Frequenzkomponenten mit einer gesteuerten relativen Phase zwischen den Komponenten, wo mindestens eine der höherfrequenten Komponenten aus einem geradzahligen Vielfaches der niedrigerfrequenten Komponente besteht, wobei die DC-Eigenvorspannung der Hüllen zwischen dem Plasma und den Elektroden durch Abstimmen der relativen Phase linear angepasst wird.

**2.** Verfahren nach Anspruch 1, wobei die DC-Eigenvorspannung durch Variieren der relativen Phase zwischen den harmonischen Komponenten der angelegten Spannung und/oder durch Variieren der Amplituden der harmonischen Komponenten der angelegten Spannung dynamisch gesteuert wird.

**3.** Verfahren nach Anspruch 1 oder 2, wobei die relative Phase der harmonischen Komponente der angelegten Spannung festgelegt ist.

**4.** Verfahren nach Anspruch 1 oder 3, wobei die Amplituden der harmonischen Komponenten der angelegten Spannung festgelegt sind.

**5.** Verfahren nach einem der vorangehenden Ansprüche, wobei die mindestens zwei harmonischen Frequenzkomponenten mit einer gesteuerten relativen Phase der HF-Spannung an eine Elektrode angelegt werden.

**6.** Verfahren nach einem der vorangehenden Ansprüche, wobei eine von den höherfrequenten Komponenten der angelegten Spannung die zweite Harmonische der niedrigeren Frequenz ist.

**7.** Verfahren nach einem der vorangehenden Ansprüche, wobei das Verhältnis der Ionenenergien an den Elektroden durch Abstimmen der relativen Phase zwischen den mindestens zwei Frequenzen variiert wird.

**8.** Verfahren nach einem der vorangehenden Ansprüche, wobei die relative Phase verwendet wird, um den Grad der Asymmetrie in den Hüllen zwischen dem Plasma und den Elektroden zu steuern, um die Ionenenergie zu verstärken oder zu verringern.

**9.** Verfahren nach einem der Ansprüche 1 bis 8, wobei das Plasma durch die HF-Spannung erzeugt wird, die auch die DC-Eigenvorspannung bewirkt (100, 500, 600 oder 900).

**10.** Verfahren nach einem der vorangehenden Ansprüche, wobei das Plasma für eine Oberflächenmodifikation, zur Dünnschichtabscheidung, zum Plasmaätzen, zum Plasmaätzen dielektrischer Substrate, zum Herstellen von Halbleitervorrichtungen, für Vorrichtungen mikroelektromechanischer Systeme (MEMS), für Solarzell- (photovoltaische) Paneele oder für Flachbildfernseher-Displays, zur Sputter-Behandlung von Oberflächen, zum Modifizieren von Oberflächen aus der Gasphase, zum Reinigen von Oberflächen, zum Steuern von Oberflächenenergien, zur Biokompatibilitätsverbesserung, zur Haftungsverstärkung, zur Herstellung von Nanopartikeln, zur Einfügung von Nanopartikeln in Strukturen oder Vorrichtungen und/oder für die oberflächliche Vernetzung von Polymeren verwendet wird.

EP 2 249 372 B1

**11.** Verfahren nach einem der vorangehenden Ansprüche, wobei eine Asymmetrie in der Plasmahüllenregion (116 oder 118) die DC-Eigenvorspannung bewirkt.

**12.** Verfahren nach einem der vorangehenden Ansprüche, wobei eine von den beiden oder mehreren Elektroden eine Wand (112) einer Vakuumkammer und/oder ein Teil einer Vakuumpumpe (108) ist.

**Revendications**

**1.** Procédé d'ajustement d'une autopolarisation en courant continu devant des électrodes (102, 106, 108, 112, 508, 512, 608, 612, 632, 708, 808, 908 ou 912) dans un appareil de traitement par plasma (100, 500, 600, 700, 800 ou 900) par application d'une tension RF avec au moins deux composantes de fréquence harmonique ayant une phase relative commandée entre les composantes, au moins l'une des composantes de fréquence supérieure étant établie en tant que multiple paire de la composante de fréquence inférieure, l'autopolarisation en courant continu des gaines entre le plasma et les électrodes étant ajustée de manière linéaire par réglage de la phase relative.

**2.** Procédé selon la revendication 1, dans lequel l'autopolarisation en courant continu est commandée de manière dynamique par variation de la phase relative entre les composantes harmoniques de la tension appliquée et/ou par variation des amplitudes des composantes harmoniques de la tension appliquée.

**3.** Procédé selon l'une des revendications 1 ou 2, dans lequel la phase relative de la composante harmonique de la tension appliquée est fixe.

**4.** Procédé selon l'une des revendications 1 ou 3, dans lequel les amplitudes des composantes harmoniques de la tension appliquée sont fixes.

**5.** Procédé selon l'une quelconque des revendications précédentes, dans lequel les au moins deux composantes de fréquence harmonique ayant une phase relative commandée de la tension RF sont appliquées à une électrode.

**6.** Procédé selon l'une quelconque des revendications précédentes, dans lequel l'une des composantes de fréquence supérieure de la tension appliquée est la seconde harmonique de la fréquence inférieure.

**7.** Procédé selon l'une quelconque des revendications précédentes, dans lequel le rapport des énergies des ions aux électrodes est amené à varier par réglage de la phase relative entre les au moins deux fréquences.

**8.** Procédé selon l'une quelconque des revendications précédentes, dans lequel la phase relative est utilisée pour commander le degré d'asymétrie dans les gaines entre le plasma et les électrodes pour augmenter ou diminuer l'énergie des ions.

**9.** Procédé selon l'une quelconque des revendications 1 à 8, dans lequel le plasma est généré par la tension RF qui établit également l'autopolarisation en courant continu (100, 500, 600 ou 900).

**10.** Procédé selon l'une quelconque des revendications précédentes, dans lequel le plasma est utilisé pour une modification de surface, pour un dépôt de couches minces, pour une gravure au plasma, pour une gravure au plasma de substrats diélectriques, pour la fabrication de dispositifs à semi-conducteurs, de dispositifs de systèmes microélectromécaniques (MEMS), de panneaux de cellules solaires (photovoltaïques), ou de dispositifs d'affichage de télévision à écran plat, pour la pulvérisation cathodique de surfaces, la modification de surfaces en phase gazeuse, le nettoyage de surfaces, la commande d'énergies de surface, l'amélioration de la biocompatibilité, la promotion de l'adhésion, la fabrication de nanoparticules, l'assemblage de nanoparticules en des structures ou des dispositifs, et/ou la réticulation de surface de polymères.

**11.** Procédé selon l'une quelconque des revendications précédentes, dans lequel une asymétrie dans la région de gaine de plasma (116 ou 118) provoque l'autopolarisation en courant continu.

**12.** Procédé selon l'une quelconque des revendications précédentes, dans lequel l'une des au moins deux électrodes est une paroi (112) d'une chambre de vide et/ou une partie d'une pompe à vide (108).

29

FIG. 1

FIG. 2

```
┌─────────────────────────────┐
│      Select ion energy       │  ⟋ 300
│         and flux             │
└─────────────────────────────┘
              │
              ▼
┌─────────────────────────────┐
│     Adjust power deposited   │  ⟋ 302
│       into plasma for        │
│     adjusting the ion flux   │
└─────────────────────────────┘
              │
              ▼
┌─────────────────────────────┐
│  Select radio freqency voltage: │  ⟋ 304
│  the phase adjusts the ion energy │
│  and the amplitude adjusts both │
│   the ion energy and ion flux │
└─────────────────────────────┘
              │
              ▼
┌─────────────────────────────┐
│   Perform sensor or instrument │  ⟋ 306
│        measurement           │
└─────────────────────────────┘
              │
              ▼
        ◇ Sensor measurement     ⟋ 308
  No    ◇ within tolerance?  ◇
              │ Yes
              ▼
┌─────────────────────────────┐
│    Proceed with plasma       │  ⟋ 310
│        treatment             │
└─────────────────────────────┘
```

FIG. 3

FIG. 4

FIG. 5

FIG. 6

FIG. 7

FIG. 8

FIG. 9

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **COBURN ; KAY.** *J. Appl. Phys.,* 1972, vol. 43 (12), 4965-4971
- **BOYLE ; ELLINGBOE ; TURNER.** *J. Phy. D: Appl. Phys,* 2004, vol. 37, 697-701
- **U. CZARNETZKI ; T. MUSSENBROCK ; R. P. BRINKMANN.** Self-excitation of the plasma series resonance in radio-frequency discharges: An analytical description. *Phys. Plasmas,* 2006, vol. 13, 123503
- **RALF PETER BRINKMANN.** Beyond the step model: Approximate expressions for the field in the plasma boundary sheath. *J. Appl. Phys.,* 2007, vol. 102, 093303
- **C. WILD ; P. KOIDL.** *Ion and electro dynamics in the sheath of radio-frequency glow discharges,* March 1991, vol. 69 (5), 2909-2922
- **V. A. GODYAK ; R. B. PIEJAK ; B. M. ALEXANDROVICH.** Measurements of electron energy distribution in low-pressure rf discahrges. *Plasma Sources Sci. T.,* 1992, vol. 1, 36-58